Europäisches Patentamt

(19) European Patent Office

Office européen des brevets

(11) Publication number: **0 119 387**
**B1**

(12) EUROPEAN PATENT SPECIFICATION

(45) Date of publication of patent specification: **03.08.88**

(51) Int. Cl.⁴: **G 03 F 1/00**

(21) Application number: **84100194.4**

(22) Date of filing: **10.01.84**

(54) A method for fabricating pellicle cover for photomask.

(30) Priority: **14.02.83 US 466269**

(43) Date of publication of application:
**26.09.84 Bulletin 84/39**

(45) Publication of the grant of the patent:
**03.08.88 Bulletin 88/31**

(84) Designated Contracting States:
**DE FR GB NL**

(56) References cited:
**US-A-4 246 054**
**US-A-4 254 174**

**IBM TECHNICAL DISCLOSURE BULLETIN, vol.
22, no. 10, March 1980, pages 4765-4766, New
York, US S. CHENG et al.: "Improved device for
photographic mask and wafer protection"**

(73) Proprietor: **THE PERKIN-ELMER CORPORATION
761 Main Avenue
Norwalk Connecticut 06856-0181 (US)**

(72) Inventor: **Duly, Dawn L.
4 Arrowhead Lane
Huntington Connecticut 06484 (US)**

(74) Representative: **Patentanwälte Grünecker, Dr.
Kinkeldey, Dr. Stockmair, Dr. Schumann, Jakob,
Dr. Bezold, Meister, Hilgers, Dr. Meyer-Plath
Maximilianstrasse 58
D-8000 München 22 (DE)**

Courier Press, Leamington Spa, England.

## Description

This invention relates to a method of fabricating a pellicle cover assembly for use in a projection system for forming an image on a radiation sensitive wafer, said method comprising the steps of applying a thin uniform polymer film onto a polished surface of a substrate, curing the film and soaking the so-coated substrate in water. Such a pellicle cover is particularly used for covering the mask and/or wafer. The systems according to the invention are particularly adapted, among other possible uses, for effecting the exposure of photoresist-coated semiconductor wafers in the manufacture of integrated circuits.

Projection printing systems for forming an image on a light sensitive substrate or wafer normally include a mask having a transparent substrate with a pattern of opaque and transparent areas formed on one surface thereof, an illumination system for directing a beam of radiation energy such as light or UV rays through the mask to a radiation sensitive substrate or wafer, optical means for forming a focused image of the mask pattern on the radiation sensitive substrate and a pellicle cover for maintaining the images of any dirt particles on the surface of the mask out of focus. The pellicle cover is normally bonded to the substrate and completely covers the mask pattern. Such systems, for example, are described in US—A—4,063,812; US—A—4,246,054 and US—A—4,131,363 and in an article by Ron Hershel entitled: "Pellicle Protection of Integrated Circuits (IC) Masks", appearing in SPIE, vol. 275 Semiconductor Microlithography VI. (1981) page 23.

In particular, US—A—4,246,054 discloses a method of fabricating a pellicle cover assembly for use in a projection system in which a uniform film of a monomer material is formed as a plastic membrane on a substrate member. After this monomer film has been heat cured a ring element, forming a pellicle support ring, is adhered to said membrane, providing an assembly. Afterwards, the edges of said assembly are immersed in a chemical solution to loosen a portion of the bonding between said membrane and said substrate member. Thereafter, the assembly is immersed in water to cause said substrate member to fall away from said plastic membrane secured to said ring element. Thereby, the final pellicle cover assembly is formed.

With increasing miniaturization, the pattern elements have become smaller and smaller to the extent that pattern resolution is limited by the wavelength of the light. This has led to the use of shorter wavelengths of the UV spectrum.

One disadvantage of the mask covers used heretofore is that they are only suitable for use in the wavelength range of from $4.10^{-7}$ m (4000 angstroms) and above. Thus, an object of this invention is to provide a new and improved method of making a pellicle cover that is suitable for use in the $2.10^{-7}$ m (2000 angstroms) and above range.

According to the invention, a method of fabricating a pellicule cover assembly as mentioned in the foregoing is provided which is characterized in that a cut is made around the circumference of the film after the curing step and that after the soaking a peeling ring is attached to the film surface, the film is peeled off with the peeling ring and a pellicle support ring is attached to the film, thereby forming said pellicle cover assembly.

According to preferred embodiments, the substrate may consist of a silicon wafer.

Furthermore, the polymer film may comprise polymethylmethacrylate.

The curing of the polymer film is mainly effected at about 170°C for a period of about one hour.

According to another preferred embodiment, the step of soaking the so-coated substrate in water comprises the step of soaking the so-coated substrate in deionized water.

Most preferably, said step of attaching said peeling ring to the film surface comprises the step of adhering a flexible, thin, flat peeling ring to the film surface by a double-sided sticky tape. Furthermore, the pellicle support ring may be attached to the film by epoxying the same.

Specific embodiments of the invention have been chosen for purposes of illustration and description, and are shown in the accompanying drawings, forming a part of this specification.

Figure 1 is a schematic drawing of a projection printing system for forming an image on a radiation sensitive wafer constructed in accordance with the concepts of the present invention; and

Figures 2 to 4 are side elevations showing the method steps involved for forming a pellicle cover assembly according to the concepts of the invention.

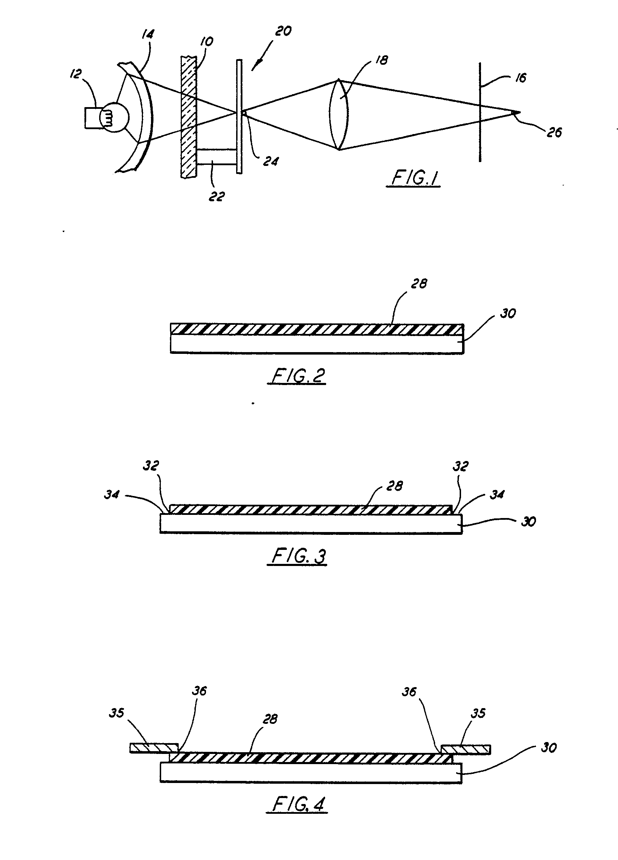

Referring to Figure 1, there is shown a projection printing system for forming an image on a radiation sensitive wafer, which comprises a mask 10 having a transparent substrate with a pattern of opaque and transparent areas formed on one surface thereof. An illuminating system is provided which includes a radiation source 12 and a condenser lens system 14 for directing radiation through the mask 10 to a radiation sensitive wafer member 16. An optical system 18 serves to form a focused image of the mask pattern on the wafer. A pellicle cover assembly 20 is mounted on the mask 10, as by means of a support ring 22. As a result, scratching or particulate contaminates 24, which would otherwise rest on the mask surface, now rest on the surface of the pellicule and hence are focused out of the focal plane by thousands of times the depth of field, as indicated at 26, Figure 1. Their shadows are dissipated over the image field and have no effect on the resist image.

According to the invention, there is provided a new and improved method of fabricating the pellicle assembly. This method comprises the steps of applying a thin uniform polymer layer or film 28 onto a polished surface of a substrate 30, as seen in Figure 2. Any suitable polymer film may be employed. For example, a suitable material is polymethylmethacrylate known as PMMA. Any suitable polished surface of a substrate may be used such as, for example, a silicon wafer. A particularly suitable way of applying the polymer film to the substrate is by means of conventional spinning techniques.

The next step in the method is to cure the polymer, conditions being contingent on the polymer. PMMA for example must be baked at 170°C for one hour. Thereafter, with a suitable tool such as a razor blade or the like, a circular cut is made around the circumference of the film as indicated at 32 in Figure 3. This cut is made through the polymer layer 28 so that the wafer 30 is exposed, as indicated at 34, Figure 3. This provides an edge where fluid can enter between the polymer film and the wafer 30.

The so-coated wafer is then soaked in deionized wafer for a suitable period of time. The polymer expands in the water and loosens its adhesion or bonding to some extent with respect to the wafer surface, thereby preparing the polymer layer 28 for subsequent removal from the substrate or wafer 30.

Next, a flexible, thin, flat, preferably aluminum, peeling ring 35 is attached to the film surface as indicated at 36 in Figure 4. A suitable adhering agent is employed for this application such as, for example, double sided sticky tape.

The film 28 is carefully peeled off the wafer 30 with the peeling ring 35.

To complete the pellicle cover assembly 20, this film 28 is then attached to a suitable pellicle support ring 22, the design of which is dependent on the exposure tool used. A suitable adhering agent is epoxy.

It will thus be seen that the present invention does indeed provide a new and improved pellicle assembly which has a high transmission in the range of from about $2.4 \cdot 10^{-7}$ m (2400 angstroms) to about $8.10^{-7}$ m (8000 angstroms), low light scattering, and thickness uniformity, and which is rugged enough to be handled and cleaned without damage.

## Claims

1. A method of fabricating a pellicle cover assembly for use in a projection system for forming an image on a radiation sensitive wafer, said method comprising the steps of applying a thin uniform polymer film (28) onto a polished surface of a substrate (30) curing the film (28), and soaking the so-coated substrate in water characterized in that a cut is made around the circumference of the film (28) after the curing step, and that after the soaking a peeling ring (35) is attached to the film surface, the film (28) is peeled off with the peeling ring (35) and a pellicle support ring (22) is attached to the film (28), thereby forming said pellicle cover assembly.

2. A method according to Claim 1 wherein said substrate is a silicon wafer.

3. A method according to Claim 1 wherein said polymer film comprises polymethylmethacrylate.

4. A method according to Claim 3 wherein said step of curing the polymer is effected at about 170°C for a period of about one hour.

5. A method according to Claim 1 wherein said step of soaking the so-coated substrate in water comprises the step of soaking the so-coated substrate in deionized water.

6. A method according to Claim 1 wherein said step of attaching a peeling ring to the film surface comprises the step of adhering a flexible, thin, flat peeling ring to the film surface by a double sided sticky tape.

7. A method according to Claim 1 wherein said step of attaching a pellicle support ring to the film comprises the step of epoxying a pellicle support ring to the film.

## Patentansprüche

1. Verfahren zur Herstellung eines Filmabdeckungsaufbaus zur Verwendung bei einem Projektionssystem zum Erzeugen eines Bildes auf einem strahlungsempfindlichen Wafer, wobei das genannte Verfahren die Schritte umfaßt, eine dünne, gleichförmige Polymerschicht (28) auf eine polierte Oberfläche eines Substrats (30) aufzubringen, die Schicht (28) zu härten und das derart beschichtete Substrat in Wasser einzutauchen, dadurch gekennzeichnet, daß nach dem Härtungsschritt ein Schnitt um den Umfang der Schicht (28) herum durchgeführt und nach dem Eintauchen ein Abziehring (35) an der Schichtoberfläche angebracht wird, die Schicht (28) mit dem Abziehring (35) abgezogen und ein Filmhaltering (22) an der Schicht (28) angebracht wird, wodurch der genannte Filmabdeckungsaufbau gebildet wird.

2. Verfahren nach Anspruch 1, bei dem das genannte Substrat ein Siliciumwafer ist.

3. Verfahren nach Anspruch 1, bei dem die Polymerschicht Polymethylmethacrylat umfaßt.

4. Verfahren nach Anspruch 3, bei dem der genannte Härtungsschritt des Polymers bei ungefähr 170°C während einer Zeitdauer von ungefähr einer Stunde durchgeführt wird.

5. Verfahren nach Anspruch 1, bei dem der genannte Schritt des Eintauchens des derart beschichteten Substrats in Wasser den Schritt umfaßt, das derart beschichtete Substrat in entionisiertes Wasser einzutauchen.

6. Verfahren nach Anspruch 1, bei dem der genannte Schritt des Anbringens eines Abziehringes an der Schichtoberfläche den Schritt umfaßt, einen flexiblen, dünnen, flachen Abziehring an der Schichtoberfläche mittels eines beidseitig klebenden Bandes anzubringen.

7. Verfahren nach Anspruch 1, bei dem der genannte Schritt des Anbringens eines Filmhalterings an der Schicht den Schritt umfaßt, einen Filmhalterung mittels Epoxymaterials an der Schicht anzubringen.

## Revendications

1. Procédé de fabrication d'un ensemble d'opercule pelliculaire pour photomasque utilisable dans une système de projection pour former une image sur une plaque sensible au rayonnement, ledit procédé comprenant les étapes d'application d'un film polymère (28) uniforme et mince sur une surface polie d'un substrat (30), de cuisson du film (28) et de trempage dans l'eau du substrat ainsi revêtu, caractérisé en ce qu'une découpe est faite autour de la périphérie du film (28) après l'étape de cuisson et en ce qu'après le trempage un anneau de décollement (35) est fixé à la surface du film, le film (28) est décollé avec l'anneau de décollement (35) et un anneau (22) support de pellicule est fixé au film (28), l'ensemble d'opercule pelliculaire se trouvant ainsi formé.

2. Procédé selon la revendication 1, caractérisé en ce que ledit substrat est une plaque de silice.

3. Procédé selon la revendication 1, caractérisé en ce que le film polymère est du polyméthacrylate.

4. Procédé selon la revendication 3, caractérisé en ce que ladite étape de cuisson du polymère est effectuée à environ 170°C pendant une durée d'environ une heure.

5. Procédé selon la revendication 1, caractérisé en ce que ladite étape de trempage dans l'eau du substrat revêtu comprend l'étape de trempage dans de l'eau désionisée du substrat ainsi revêtu.

6. Procédé selon la revendication 1, caractérisé en ce que ladite étape de fixation d'un anneau de décollement à la surface du film comprend l'étape de collage d'un anneau de décollement plat, mince et flexible à la surface du film au moyen d'un ruban collant sur ces deux faces.

7. Procédé selon la revendication 1, caractérisé en ce que ladite étape de fixation d'un anneau support de pellicule sur le film comprend l'étape d'époxydation d'un anneau support de pellicule sur le film.

FIG.1

FIG.2

FIG.3

FIG.4

1